(19) Europäisches Patentamt

European Patent Office

Office européen des brevets

(11) **EP 1 628 145 A2**

(12) **EUROPEAN PATENT APPLICATION**

(43) Date of publication:
**22.02.2006 Bulletin 2006/08**

(51) Int Cl.:
*G02B 3/00* (2006.01)   *G02B 1/02* (2006.01)
*G12B 21/06* (2006.01)   *G11B 7/135* (2006.01)

(21) Application number: **05016317.9**

(22) Date of filing: **27.07.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **27.07.2004 JP 2004218878**

(71) Applicant: **SONY CORPORATION**
**Tokyo (JP)**

(72) Inventor: **Shinoda, Masataka**
**Shinagawa-ku**
**Tokyo (JP)**

(74) Representative: **Körber, Martin Hans**
**Mitscherlich & Partner**
**Patentanwälte**
**Sonnenstrasse 33**
**80331 München (DE)**

(54) **Optical lens, optical pick up device, and optical recording and reproducing device**

(57)    With an optical lens (11) made of a $Y_3Al_5O_{12}$ monocrystal material of a cubic crystal structure, an optical lens having a high refractive index and a low optical absorption property in the range from an ultraviolet light wavelength to a visible light wavelength is provided, and using this optical lens, an optical lens and a focusing lens suitable for a near-field optical recording and reproducing method are provided, and further an optical pickup device and an optical recording and reproducing device to cope with an increase in density and capacity of an optical recording medium (30) are provided.

FIG. 2

EP 1 628 145 A2

**Description**

CROSS REFERENCES TO RELATED APPLICATIONS

The present invention contains subject matter related to Japanese Patent Application JP 2004-218878 filed in the Japanese Patent Office on July 27, 2004, the entire contents of which being incorporated herein by reference.

BACKGROUND OF THE INVENTION

Field of the Invention:

The present invention relates to an optical lens, focusing lens, optical pickup device and optical recording and reproducing device which are particularly suitable for application to what is called a near-field optical recording and reproducing method of performing recording and/or reproduction by irradiating near-field light onto an optical medium.

Description of the Related Art:

Optical recording media (including magneto-optical recording media) represented by a CD (Compact Disc), MD (Mini Disc), and DVD (Digital Versatile Disc) are widely used as storage media for audio data, video data, data, program, and the like. However, there have been desired an optical recording medium having further large capacity and an optical recording and reproducing device in which recording and reproduction are performed on the recording medium, because higher sound quality, higher picture quality, longer duration, and larger capacity of the audio data, video data, data, program, and the like are in progress.

Then, in order to cope with the above, in an optical recording and reproducing device a wavelength has been made shorter in a light source such as a semiconductor laser, for example, a numerical aperture of a focusing lens has been attempted to increase and a diameter of a light spot focused through the focusing lens has been made small.

For example, with respect to the semiconductor laser, a GaN semiconductor laser whose oscillation wavelength 635 nm of a red laser in related art is made into a shorter wavelength of 400 nm band has been brought into a practical use, and thereby the diameter of the light spot is being reduced. In addition, with respect to the attempt for obtaining further shorter wavelength, for example, a far-ultraviolet solid state laser UW-1010 continuously oscillating light of a single wavelength of 266 nm, which is manufactured by Sony Corp., and the like has been put into commercial production, and further reduction in diameter of the light spot has been attempted. Further, other than that, a double-wave laser of Nd:YAG laser (266 nm band), a diamond laser (235 nm band), a double-wave laser of GaN laser (202 nm band) and the like have been studied and developed.

In addition, a focusing lens having a numerical aperture of 1 or more, for example, is obtained by using an optical lens of a large numerical aperture that is represented by a solid immersion lens, for example, and what is called a near-field optical recording and reproducing method for performing recording and reproduction by bringing an object-side surface of this focusing lens close to an optical recording medium up to a distance of approximately 1/10 of a light source wavelength thereof has been studied.

In order to make a transfer rate higher in this near-field optical recording and reproducing method, it is important to make a disc rotate at a high speed while maintaining the distance between the optical recording medium and the focusing lens within a state of optical contact.

Moreover, there exists greater restrictions in terms of the shape of a focusing lens, because a diameter of light beam emitted from the light source and incident on the focusing lens becomes small and the distance between the optical recording medium and the focusing lens becomes considerably small.

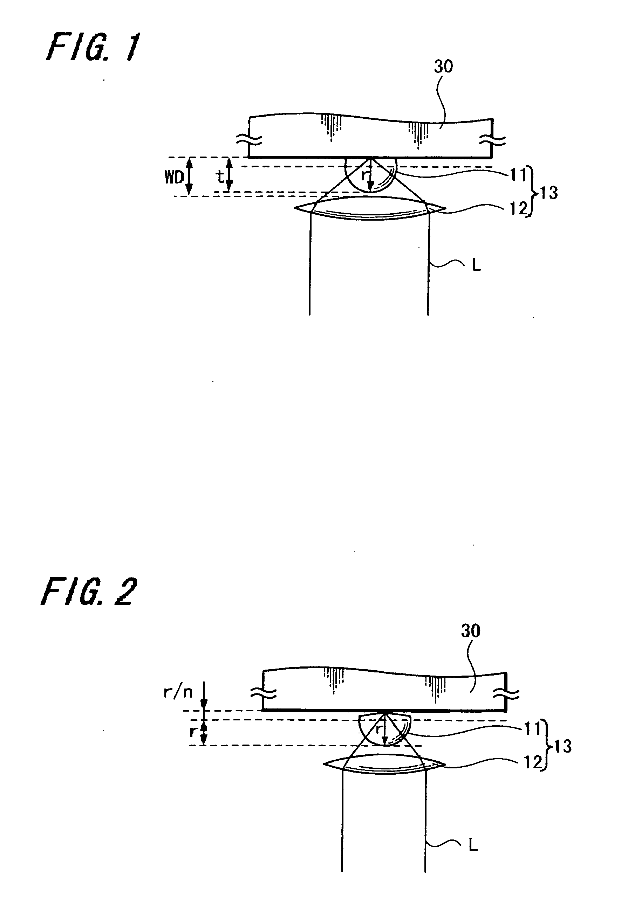

FIG. 1 shows a schematic configuration of an optical system applicable to the near-field optical recording and reproducing method which uses the above-described solid immersion lens, for example. A first optical lens 11 of a super-hemispheric type structure, for example, and a second optical lens 12 are disposed in order from the object side facing a recording surface of an optical recording medium 30 to form a near-field focusing lens 13.

With respect to the first optical lens 11, there is the following relation:

$$t = r(1 + 1/n)$$

where r is a curvature radius, n is a refractive index of an optical lens material, and t is a thickness along an optical axis direction of the lens. The refractive index of $SiO_2$ which is typically used as optical glass, is approximately 1.5.

In addition, when WD is a distance between the second optical lens 12 and the optical recording medium 30 as shown in FIG. 1, the thickness t of this first optical lens 11 needs to satisfy a condition of

$$t = r(1 + 1/n) < WD$$

When the refractive index is 1.5, it is necessary to satisfy

$$t = 1.667r < WD$$

Note that the distance WD between the second optical lens 12 and the optical recording medium 30 is determined by the numerical aperture of the second optical lens 12.

Therefore, in order to obtain a distance between the first optical lens 11 and the second optical lens 12 suitably and easily, it is necessary to make the curvature radius r as small as possible, or to make the refractive index n of the optical lens material as large as possible.

At present, in the case where the optical glass ($SiO_2$) is used as the material, there exists a limit of approximately 1.5 with respect to the refractive index of the optical lens (refer to Patent reference 1, for example).

[Patent reference 1] Japanese Patent Application Publication No. 2002-249341

SUMMARY OF THE INVENTION

However, it is difficult to make the curvature radius of an optical lens small to be about 1 mm or less in view of an assembly accuracy of an optical pickup device. In other words, in the near-field optical recording and reproducing method as described above, the focusing lens typically obtains the numerical aperture of 1 or more by combining two optical lenses of the first optical lens and second optical lens disposed in order from the object side; however, the larger the numerical aperture becomes, the higher the accuracy is required for the assembly of these first optical lens and second optical lens, and this accuracy is required to be maintained even if the environment is changed, so that it is difficult to obtain the accuracy in assembling the near-field focusing lens when the curvature radius of the optical lens is considerably small.

In addition, since there is the limit of approximately 1.5 in the refractive index of the optical glass as described above, it has been difficult to further make the thickness of the optical lens thin.

On the other hand, in order to obtain a higher density in this near-field optical recording and reproducing method, it is necessary to reduce the focusing spot with a reduction in wavelength of an emission wavelength of the light source and with an increase in numerical aperture of the focusing lens, similarly to an optical recording method in related art. Here, since an area of the focusing spot is inversely proportional to the square of the numerical aperture of the focusing lens, it is efficient to make the numerical aperture of the focusing lens increase in order to obtain a higher density in the near-field optical recording and reproducing method.

For example, as shown in FIG. 1, a numerical aperture NA of the near-field focusing lens in the case in which the first optical lens is the super-hemispheric optical lens is expressed as follows:

$$NA = n \times \sin(\tan^{-1}(n))$$

where n is the refractive index of the first optical lens.

In the past, since glass ($SiO_2$) is used as the material for these first and second optical lenses, the refractive index is limited to approximately 1.5 in a range from an ultraviolet light wavelength to a visible light wavelength, and in case of the super-hemispheric optical lens, for example, the numerical aperture NA of the near-field focusing lens becomes:

$$NA = 1.5 \times \sin(\tan^{-1}(1.5)) = 1.25$$

and it has been difficult to increase the numerical aperture NA more than that. Accordingly, there is a limit when obtaining a higher density in the near-field focusing lens that uses glass material in the past.

The present invention addresses the above-identified and other problems associated with conventional methods and devices, and provides: an optical lens having a high refractive index at least in a range from the ultraviolet light wavelength to the visible light wavelength; an optical lens and focusing lens suitable for the near-field optical recording and reproducing method using the optical lens; and an optical pickup device and optical recording and reproducing device that correspond to an increase in density and capacity of an optical recording medium.

In order to solve the above-described problems, an optical lens according to an embodiment of the present invention is made of $Y_3Al_5O_{12}$ monocrystal material of a cubic crystal structure.

Further, according to an embodiment of the present invention, part of a convex spherical surface is formed at least on the side opposite to an object-side surface in the optical lens.

Further, a focusing lens according to an embodiment of the present invention is at least formed of a first optical lens and a second optical lens whose optical axes are approximately aligned and which are disposed in order from the object side, in which at least a material constituting the first optical lens is $Y_3Al_5O_{12}$ monocrystal material of the cubic crystal structure.

Furthermore, in the focusing lens according to an embodiment of the present invention, the first optical lens is configured such that part of the convex spherical surface is formed at least on the side opposite to an object-side surface.

Further, an optical pickup device according to an embodiment of the present invention includes at least a light source, a first optical lens and second optical lens disposed in order from the object side, and a focusing lens to form a light spot by focusing light emitted from the light source on a predetermined track position on an optical recording medium, in which at least a material constituting the first optical lens is $Y_3Al_5O_{12}$ monocrystal material of the cubic crystal structure.

Moreover, in the optical pickup device according to an embodiment of the present invention, the first optical lens is configured such that part of the convex spherical surface is formed at least on the side opposite to the object-side surface.

Further, in each of the optical pickup devices according to embodiments of the present invention, the optical recording medium is irradiated with near-field light by the focusing lens.

Furthermore, an optical recording and reproducing device according to an embodiment of the present invention includes at least an optical pickup device that has a light source, a first optical lens and second optical lens disposed in order from the object side, a focusing lens to form a light spot by focusing light emitted from the light source on a predetermined track position on an optical recording medium, and control drive means for controlling and driving the focusing lens in a focusing direction and/or tracking direction of the optical recording medium, in which a material constituting the first optical lens is $Y_3Al_5O_{12}$ monocrystal material of the cubic crystal structure.

Furthermore, in the optical recording and reproducing device according to an embodiment of the present invention, the first optical lens is configured such that part of the convex spherical surface is formed at least on the side opposite to the object-side surface.

Moreover, in each of the optical recording and reproducing devices according to embodiments of the present invention, the optical recording medium is irradiated with near-field light by the focusing lens to perform recording and/or reproduction.

As described above, since the optical lens according to an embodiment of the present invention is made of $Y_3Al_5O_{12}$ monocrystal material having the cubic crystal structure, the optical lens having the refractive index of 1.8 or more which has not been obtained in the optical lens made of glass material used in the past can be obtained.

Further, since the optical lens made of $Y_3Al_5O_{12}$ monocrystal material having the cubic crystal structure is excellent in optical transmissivity with respect to light of a wide wavelength band from 250 nm to 1,000 nm, an optical efficiency in recording and reproduction with respect to optical power from a light source can be improved.

Further, a focusing lens having the numerical aperture of 1.5 or more can be obtained easily in the range from the ultraviolet light wavelength to the visible light wavelength, when using this optical lens to constitute the optical lens of the solid immersion lens type structure, for example, in which the convex spherical surface is provided on the surface on the side opposite to the object side, and combining this lens as the first optical lens with the second optical lens.

Then, in an optical pickup device and optical recording and reproducing device including this focusing lens, since a diameter of a light beam incident on the second optical lens constituting the focusing lens can be reduced, a reduction in size and weight of the focusing lens which is controlled and driven in the focusing direction and/or tracking direction of the optical recording medium can be achieved, and accordingly servo characteristics such as focusing servo, tracking servo, seek time and the like can be improved.

As explained above, since the optical lens according to an embodiment of the present invention is made of $Y_3Al_5O_{12}$ monocrystal material of the cubic crystal structure, the optical lens having the refractive index of 1.8 or more that can be applied to the light whose wavelength is 250 nm or more can be provided.

Moreover, this optical lens is configured such that the convex spherical surface is provided at least on the side opposite to the object side, and thereby it is possible to configure the focusing lens having the large numerical aperture by using this optical lens.

In addition, according to an embodiment of the focusing lens of the present invention, since the first optical lens having the large refractive index is used, the focusing lens having the large numerical aperture can be provided.

Furthermore, in the focusing lens according to an embodiment of the present invention, since the first optical lens is configured such that the convex spherical surface is provided at least on the side opposite to the object side, it is possible to provide the focusing lens whose numerical aperture is 1.5 or more.

Further, according to embodiments of the optical pickup device and optical recording and reproducing device of the present invention, it is possible to make the numerical aperture large and to improve recording and reproducing characteristics.

Furthermore, in the optical pickup device and optical recording and reproducing device, since the first lens is configured such that the convex spherical surface is provided on the side opposite to the object side, the numerical aperture of the focusing lens is made into 1.5 or more and the recording and reproducing characteristics can be improved.

Moreover, in the optical pickup device and optical recording and reproducing device according to embodiments of the present invention, the near-field recording and reproduction can be performed excellently with the configuration irradiated with the near-field light.

BRIEF DESCRIPTION OF THE DRAWINGS

FIG. 1 is a schematic constitutional diagram showing an example of a focusing lens;

FIG. 2 is a schematic constitutional diagram showing a focusing lens including an optical lens according to an embodiment of the present invention;

FIG. 3 is a schematic constitutional diagram showing a relevant part of an optical pickup device according to an embodiment of the present invention;

FIG. 4 is a schematic constitutional diagram showing a relevant part of an optical recording and reproducing device and optical pickup device according to an embodiment of the present invention;

FIG. 5 is a schematic constitutional diagram showing a relevant part of an optical recording and reproducing device and optical pickup device according to an embodiment of the present invention;

FIG. 6 is a schematic constitutional diagram showing a relevant part of an optical recording and reproducing device and optical pickup device according an embodiment of to the present invention;

FIG. 7 is a characteristic curve showing a wavelength dependence in a refractive index of an optical lens according to an embodiment of the present invention; and

FIG. 8 is a characteristic curve showing a wavelength dependence in a refractive index of an optical lens in related art.

DESCRIPTION OF THE PREFERRED EMBODIMENTS

Hereinafter, preferred embodiments of the present invention are explained, however, the present invention is not limited thereto.

The present invention can be applied to an optical lens, a focusing lens including the optical lens as a first optical lens and a second optical lens which are disposed in order from an object side, an optical pickup device configured to have this focusing lens and to employ what is called a near-field optical recording and reproducing method and an optical recording and reproducing device including this optical pickup device. Hereinafter, the embodiments according to the present invention are explained by referring to FIGS. 2 through 6. Note that to elements in these figures whose structures are similar to those in the related art, the same reference numerals are given.

FIG. 2 is a schematic constitutional diagram showing an example of the focusing lens using the optical lens according to an embodiment of the present invention.

The focusing lens is configured such that with respect to, for example, the optical recording medium 30 that is an object of the lens, the first optical lens 11 according to an embodiment of the present invention, specifically, made of $Y_3Al_5O_{12}$ monocrystal material of the cubic crystal structure and the second optical lens 12 are disposed in this order with optical axes approximately aligned. In this embodiment, the first optical lens 11 is made into a solid immersion lens (SIL) type structure and is configured to be a super-hemispheric form having a radius r, for example, specifically the side opposite to the object side being configured to have a convex spherical surface. In this case, a thickness along the optical axis is maid into $r(1+1/n)$. With this configuration, the focusing lens 13 capable of focusing light L on the optical recording medium 30 with a higher numerical aperture exceeding the numerical aperture NA of the optical lens 12 can be provided.

It should be noted that the optical lens 11 of the SIL type and the recording medium 30 are actually not in contact with each other, but a space between this first optical lens 11 and the optical recording medium 30 is sufficiently small in comparison with the thickness of the first optical lens 11, and so the space is omitted and not shown in FIGS. 2 through 6.

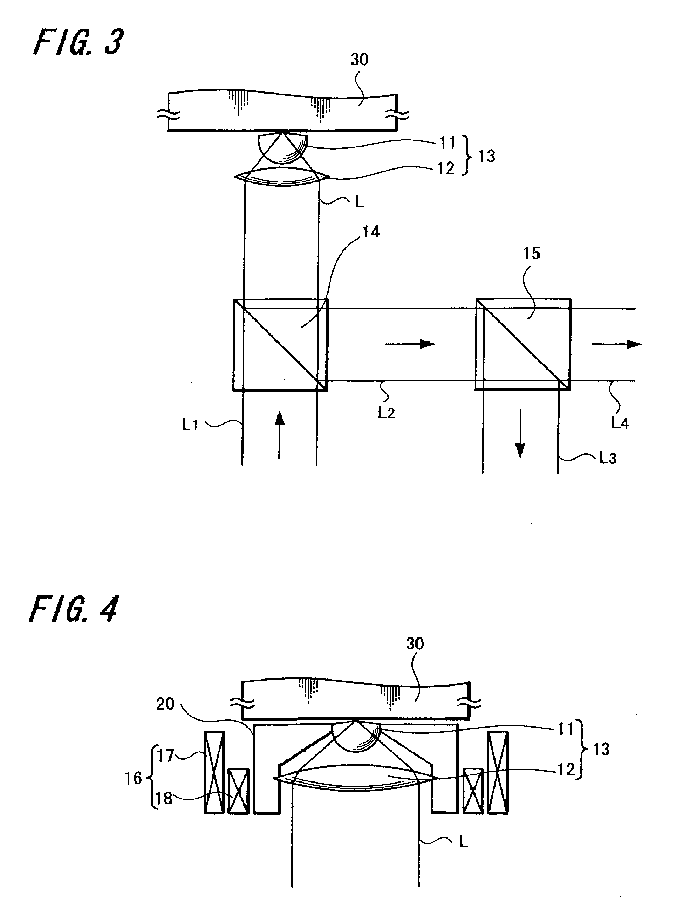

FIG. 3 is a schematic constitutional diagram showing an example of a configuration of an optical system in an optical pickup device using the focusing lens according to an embodiment of the configuration of the present invention shown in FIG. 2. First and second beam splitters 14 and 15, for example, are disposed between a light source and photo-detector which are not illustrated and the focusing lens 13 including the first and second optical lenses 11 and 12. When being disc-shaped, for example, the optical recording medium 30 is loaded on a spindle motor not shown in this figure, and is rotated at a predetermined rotational speed.

FIG. 4 is a schematic constitutional diagram showing a relevant part of an example of an optical recording and reproducing device. When being disc-shaped, for example, an optical recording medium 30 is loaded on a spindle motor not shown in the figure, and is rotated at a predetermined rotational speed. The focusing lens 13 configured to have the first optical lens 11 and second optical lens 12 in this order from the side of the optical recording medium 30 is fixed through a holding body 20 to a biaxial actuator 16 made of a tracking coil 17 and focusing coil 18 controlled and driven in the focusing direction and/or the tracking direction, for example. This biaxial actuator 16 is capable of controlling the distance between the optical recording medium 30 and the first optical lens 11. Specifically, by monitoring an amount of return light, for example, and by feeding back distance information, the distance between the first optical lens 11 and the optical recording medium 30 can be kept constant and also a control mechanism is provided in order to avoid a collision of the first optical lens 11 with the optical recording medium 30. In addition, this biaxial actuator 16 is capable of moving a focusing spot to a desired recording track by monitoring the amount of return light in the tracking direction and by feeding back the position information thereof.

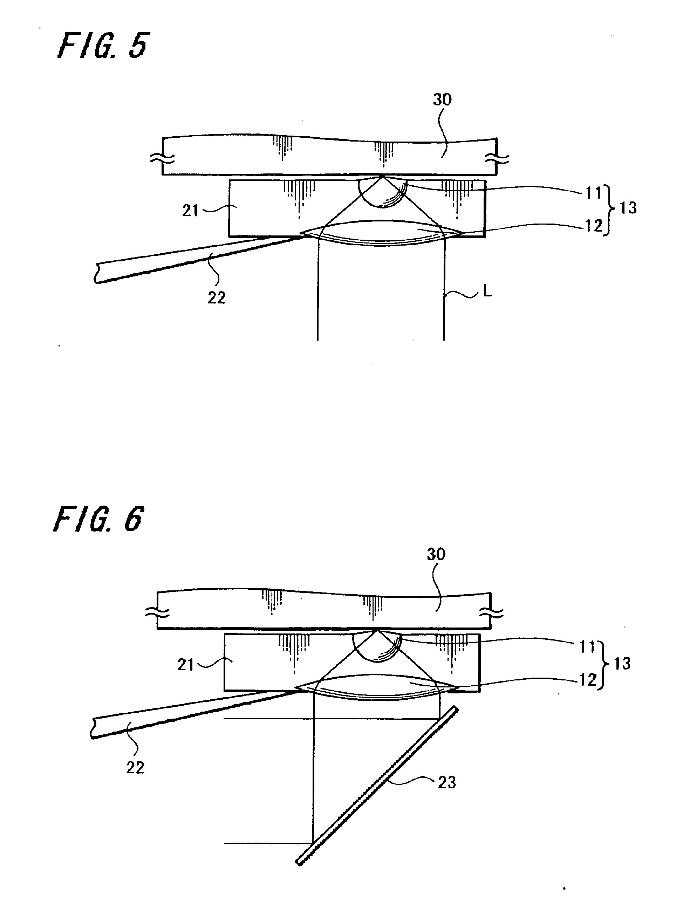

Moreover, as shown in a schematic constitutional diagram of FIG. 5, the focusing lens 13 configured to have the first optical lens 11 and the second optical lens 12 in this order from the side of the optical recording medium 30 can be configured to be fixed to a slider 21 controlled and driven in the tracking direction. This slider 21 is supported by a movable optical portion constituting the optical pickup device and capable of moving in the tracking direction through gimbals 22 having elasticity only in a surface contact direction of the optical recording medium 30, for example, or through other elastic bodies not illustrated. This movable optical portion is controlled and driven in the tracking direction by a control-drive mechanism formed of a linear motor or the like. Further, since a gaseous flow generated along the rotation of the optical recording medium 30 enters the space between the optical recording medium 30 and the slider 21 to form a gaseous thin film balancing with a thrust force of the elastic body toward the optical recording medium 30, the slider 21 floats keeping a constant distance such as a distance of 50 nm, for example, with respect to an optical recording medium. Specifically, the distance between the first optical lens 11 constituting the focusing lens 13 and the optical recording medium 30 is made into a state where the almost constant distance is maintained by the slider 21, when reproducing data from the optical recording medium 30 or when recording data onto the optical recording medium 30 while rotating the optical recording medium 30 at the predetermined rotational speed.

Hereinafter, a schematic configuration of the optical pickup device is explained by again referring to FIG. 3. Forwarding light emitted from a light source such as a semiconductor laser is made into parallel light L1 by a collimator lens (not illustrated), is transmitted through the first beam splitter 14 and is focused on the information recording surface of the optical recording medium 30 through the focusing lens 13. Return light reflected from the information recording surface is transmitted through the focusing lens 13, is reflected by the first beam splitter 14 and is incident on the second beam splitter 15. The return light L2 transmitted through the second beam splitter 15 is focused on a focusing photo-detector, in which a focusing error signal, a reproduction pit signal, and the like are detected. In addition, the return light reflected from the second beam splitter 15 is focused on a tracking photo-detector, in which a tracking error signal is detected. If it is necessary, this optical pickup device may include a biaxial actuator to fix the focusing lens 13 against a surface wobble of the optical recording medium 30, or a relay lens inserted between the first beam splitter 14 and the second optical lens 12, which corrects a remaining focus error component followed by the slider and an error component generated at the time of assembly process of the focusing lens and which is capable of performing a correction by changing an interval between the two lenses. In addition, when the first optical lens 11 and the second optical lens 12 are fixed to the slider 21, the first optical lens 11 constituting the focusing lens 13 may be fixed to the slider 21 and the second optical lens 12 may be made movable in the direction of an optical axis by using a piezoelectric element and the like, for example, as a mechanism to correct the remaining focus error component followed by the slider 21 and the error component generated at the time of assembly process of the focusing lens 13.

Further, in case of an optical recording and reproducing device in which a spindle motor has a mechanism to load a plurality of optical recording media, it is suitable to have such a configuration that a mirror 23 bending the optical axis by almost 90° is provided with the slider 21 as shown in a schematic constitutional diagram of FIG. 6. Since the optical recording and reproducing device having such configuration can make spaces between the optical recording media small, consequentially a reduction in size and in thickness of the device can be achieved. In FIG. 6, the same reference numerals are given to those corresponding to FIG. 5 and the duplicated explanation thereof is omitted.

It should be noted that the above-described optical pickup device may be the one only for reproduction, that is, exclusively performing reproduction, the one only for recording, that is, exclusively performing recording, or the one for recording and reproduction which is capable of performing both recording and reproduction. Moreover, each of the optical pickup devices described above and optical recording and reproducing devices including the optical pickup devices may have the configuration in which a magnetic coil and the like are incorporated in a portion of this optical pickup device by combining a magneto-optical recording method and near-field optical reproducing method. Further, the optical recording and reproducing device may be the one only for reproduction, that is, exclusively performing reproduction, the one only for recording, that is, exclusively performing recording, or the one for recording and reproduction which is capable of performing both recording and reproduction.

Next, the shape of the first optical lens is explained. The first optical lens has the configuration in which the convex spherical surface is provided on the side opposite to the object side as shown in FIGS. 2 through 6. In addition, a circumferential side surface thereof becomes a surface to be fixed to the biaxial actuator or the slider.

Moreover, this first optical lens may be an optical lens of the super-hemispheric shape whose thickness is r (1+1/n) as the example shown in the figure, and can also be made into a lens of a hemispheric shape.

Further, in the near-field optical recording and reproducing method, since the distance between the optical recording medium 30 and the first optical lens 11 is approximately several tens nm which is considerably close, the object-side surface of the first optical lens 11 can also be processed into a conical form or the like as the example shown in the figure in order to increase an allowance to an inclination of the optical recording medium 30 or first optical lens 11.

Moreover, in the near-field optical recording and reproducing method for the magneto-optical recording medium, since a magnetic field is necessary at the time of recording and/or at the time of reproduction, such configuration may be provided that a magnetic coil and the like are attached to a portion of the object-side surface of the first optical lens 11.

In embodiments of the present invention, at least the first optical lens 11 is made of $Y_3Al_5O_{12}$ monocrystal having the cubic crystal structure. This material is made of monocrystal which causes neither scattering nor absorption of incident light because there is neither grain boundary in a polycrystalline material nor a stria in a glass material, and therefore this material is suitable as an optical lens material.

Further, $Y_3Al_5O_{12}$ monocrystal having the cubic crystal structure has a high affinity with a manufacturing process of a semiconductor device, because the crystal structure is the cubic crystal, and therefore an etching process and polishing process for manufacturing an optical lens can be applied without difficulties.

In comparison with glass material used in the past, the optical lens material of $Y_3Al_5O_{12}$ monocrystal having the cubic crystal structure has a higher refractive index in the range of wavelength from 250 nm to 1,500 nm, and has the refractive index of 1.8 or more with respect to a wavelength from 250 nm to 350 nm which is an oscillation wavelength of an ultraviolet laser, for example. Therefore, the optical lens which uses the ultraviolet laser for the light source and which is made of $Y_3Al_5O_{12}$ monocrystal having the cubic crystal structure as the optical lens material is greatly efficient as a means for increasing the numerical aperture of the focusing lens in the optical recording and reproducing method, and the optical lens is able to contribute to an increase in density and capacity of the optical recording medium.

In addition, since the material has an optical isotropy that the refractive index is constant irrespective of a crystal axis thereof when the cubic crystal being selected as the crystal structure of $Y_3Al_5O_{12}$ monocrystal, it is possible to perform cutting, processing and polishing without paying attention to the direction of the crystal axis when manufacturing an optical lens of a true spherical form in a process at the time of manufacturing the first optical lens, for example, and therefore the material can be processed at the cost equivalent to that of the glass material.

Further, as a method for manufacturing the optical lens material of $Y_3Al_5O_{12}$ monocrystal having the cubic crystal structure, a Czochralski growth method can be used, for example.

Furthermore, since this material has the high refractive index, it is possible to reduce the thickness t of the focusing lens when being configured using the optical lens of the SIL type structure, as explained in detail in a later described embodiment, and therefore the reduction in size and thickness of the optical lens can be achieved and the focusing lens can be mounted on an optical pickup device, an optical recording and reproducing device, and the like at comparatively low costs.

Further, in the optical lens material of $Y_3Al_5O_{12}$ monocrystal having the cubic crystal structure, an absorption coefficient can be controlled to 1 cm$^{-1}$ or less with respect to the wavelength from 250 nm to 1,500 nm, in which the refractive index increases, by controlling and optimizing a defect density and impurity density, for example, and preferably by controlling this coefficient to 0.1 cm$^{-1}$ or less, an optical lens having the transmittance of 95% or more can be obtained even when the thickness of the first optical lens is 5 mm.

Next, an optical lens using $Y_3Al_5O_{12}$ monocrystal material having the cubic crystal structure as a practice example 1 and an optical lens using synthetic quartz $SiO_2$ material as a comparative example 1 are studied.

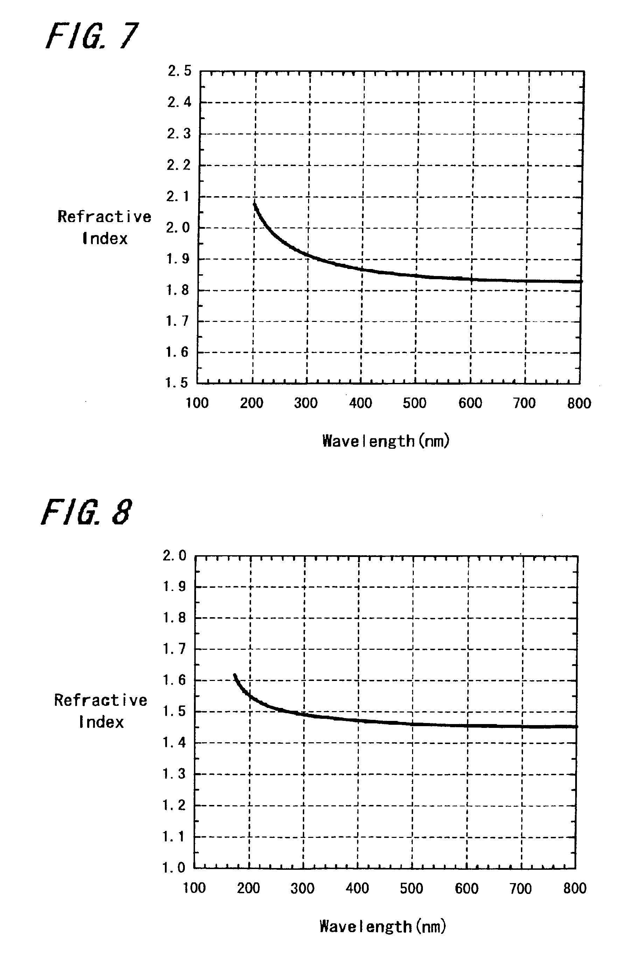

FIGS. 7 and 8 show respectively the wavelength dependence in the refractive index and in absorption coefficient of the wavelength from 250 nm to 1,000 nm, with respect to the $Y_3Al_5O_{12}$ monocrystal having the cubic crystal structure in the practice example 1 and a sample made of $SiO_2$ in the comparative example 1 for comparison.

As is obvious from FIG. 7, the refractive index of $Y_3Al_5O_{12}$ monocrystal material having the cubic crystal structure according to the practice example 1 reached 1.8 or more in all the wavelength range from 250 nm to 1,500 nm.

On the other hand, as is understood from FIG. 8, the refractive index of the $SiO_2$ material according to the comparative example 1 was around 1.5 in all the wavelength range from 250 nm to 1,500 nm.

In addition, the absorption coefficient of $Y_3Al_5O_{12}$ monocrystal having the cubic crystal structure in the practice example 1 is continuously 0.1 cm$^{-1}$ or less in the longer wavelength over the wavelength of 250 nm, so that the optical transparency (optical transmittance) is excellent, and it is understood that the optical efficiency in recording and reproduction can be improved with respect to optical power from the light source.

The following Table 1 shows the refractive index of the crystal in the practice example 1 and that of the sample of the comparative example 1 in the oscillation wavelength 266 nm of the ultraviolet laser, and shows each numerical aperture of focusing lenses when the focusing lenses having the shape such as shown in FIG. 2 are assembled by using the materials of the practice example 1 and of comparative example 1 as the first optical lens.

[Table 1]

| Sample Name | Refractive Index in Wavelength 266 nm | Numerical Aperture of Focusing Lens |
|---|---|---|
| Practice example 1 ($Y_3Al_5O_{12}$) | 1.940 | 1.72 |
| Comparative Example 1 ($SiO_2$) | 1.503 | 1.25 |

As is obvious from Table 1, when compared with $SiO_2$ materials in the past, the refractive index of the $Y_3Al_5O_{12}$ monocrystal having the cubic crystal structure and the numerical aperture of the focusing lens manufactured by using the material are obviously larger than the $SiO_2$ material.

Therefore, when a light spot is focused on an optical recording medium by using the focusing lens manufactured from the material, an area of this light spot can be reduced inversely proportional to the square of the numerical aperture, and when $Y_3Al_5O_{12}$ monocrystal having the cubic crystal structure is used, for example, an optical pickup device capable of recording to and reproducing from an optical recording medium having as high density as approximately 1.9 times in comparison with the $SiO_2$ can be obtained.

Next, the configuration of the focusing lens using $Y_3Al_5O_{12}$ monocrystal having the cubic crystal structure is explained by referring to FIG. 2 that is a schematic constitutional diagram of a focusing lens. For example, in FIG. 2, the first optical lens 11 and second optical lens 12 which are made of $Y_3Al_5O_{12}$ monocrystal having the cubic crystal structure whose refractive indices are 1.940 with respect to the wavelength of 266 nm, are disposed in this order from the side of the optical recording medium 30 to configure the focusing lens 13 with the first optical lens 11 provided as the super-hemispherical type solid immersion lens (SIL). At this time, the numerical aperture of the focusing lens 13 is 1.72.

With respect to a case where the near-field recording and reproduction are performed by using this focusing lens 13 while maintaining the distance between the first optical lens 11 and the optical recording medium 30 to be 25 nm, for example, the distance WD between the second optical lens 12 and the optical recording medium 30 is examined.

As explained in FIG. 1, in the focusing lens 13 applied to the near-field recording method shown in FIG. 2, the thickness t of the first optical lens needs to satisfy the following condition:

$$t = r(1 + 1/n) < WD$$

where WD is the distance between the second optical lens 12 and the optical recording medium 30 determined by the numerical aperture of the second optical lens 12, t is the thickness of the first optical lens 11, and r is the curvature radius of the convex spherical surface of the first optical lens 11.

Here, since the refractive indices are different in the practice example 1 and comparative example 1 as described above, the result of values of 1+1/n compared when the focusing lens is configured including the optical lens of the SIL type structure is shown in the following Table 2.

[Table 2]

| Sample Name | Refractive Index in Wavelength 266 nm | Numerical Value of (1+1/n) |
|---|---|---|
| Practice example 1 ($Y_3Al_5O_{12}$) | 1.940 | 1.515 |
| Comparative Example 1 ($SiO_2$) | 1.503 | 1.665 |

As is obvious from Table 2, when the optical glass according to the practice example 1 of the present invention was applied to the first and second optical lenses having the configuration shown in FIG. 2, the numerical value of (1+1/n) was 1.515 in the practice example 1, and the numerical value of (1+1/n) was 1.665 in the comparative example 1.

Specifically, as is obvious from this comparison, it is verified that the thickness of the first optical lens can be reduced by about 9%, because the refractive index is large in the case of $Y_3Al_5O_{12}$ monocrystal material having the cubic crystal structure whose refractive index is 1.940.

Accordingly, when being compared with the optical lens in related art, it is understood that the super-hemispheric near-field recording and reproduction can be performed with further reduced thickness that is the thickness close to the hemispheric lens. Hence, there are such advantages that the distance WD between the second optical lens and the recording medium explained in FIG. 1 can be sufficiently secured and the diameter of the light beam incident on the second optical lens can easily be reduced.

In addition, since the thickness of the first optical lens can be thus reduced, weight of the focusing lens can be reduced in comparison with that in the past. Therefore, since the weight of the focusing lens controlled and driven in the focusing direction and/or tracking direction of the optical recording medium becomes small, the servo characteristics of the focus servo, tracking servo, seek time and the like can be improved, and the reduction in size and thickness of the optical pickup device and optical recording and reproducing device can be achieved.

As explained above, according to an embodiment of the optical lens of the present invention, the lens having the large refractive index of 1.8, which has been the limit in the optical lens of related art whose material is the glass of $SiO_2$, or more in the range from the ultraviolet light wavelength to the visible light wavelength, for example, can be provided. Further, in the focusing lens including the first optical lens and second optical lens disposed in order from the object side, the focusing lens whose numerical aperture is 1.5 or more and which is compact and light-weighted can easily be obtained when at least the first optical lens is made of $Y_3Al_5O_{12}$ monocrystal material having the cubic crystal structure. Accordingly, since the area of the light spot focused by the focusing lens made of this material can be reduced, being inversely proportional to the square of the numerical aperture, the optical pickup device and optical recording and reproducing device capable of recording to and reproducing from the optical recording medium having as high density as about 1.9 times or more in comparison with that of the glass material can be obtained.

In addition, in the optical pickup device using this focusing lens and the optical recording and reproducing device including this optical pickup device, the diameter of the light beam incident on the second optical lens can be made small, consequently, it is possible to achieve the reduction in size and weight of the focusing lens controlled and driven in the focusing direction and tracking direction of the optical recording medium; it becomes possible to improve the servo characteristics of the focus servo, tracking servo, seek time and the like; and therefore the near-field recording and reproducing method can be employed to cope with the increase in density and capacity of the optical recording medium. Accordingly, an optical pickup device and optical recording and reproducing device corresponding to the wavelengths of the light source from 250 nm to 1,000 nm, such as the wavelengths of 266 nm, 292 nm, 405 nm, 635 nm, 650 nm, 780 nm, and 830 nm, for example, which are anticipated along with the increase in density and capacity of the optical recording medium in the future, can be provided.

It should be noted that the present invention is not limited to the preferred embodiments described above but is applicable to an optical lens and focusing lens of a variety of shapes and a variety of uses other than those described.

Moreover, when this invention is applied to an optical pickup device and optical recording and reproducing device, a variety of shapes may be employed without being limited to the above-described embodiments. For example, when adopting the SIL type configuration as the first optical lens, the tip thereof can be made into various shapes other than the above-described conical form and planar form, such as a convex-form portion, curved surface portion, and rough surface portion, and it is needless to say that various alterations and modifications are possible within the scope not deviating from the configuration of the present invention.

It should be understood by those skilled in the art that various modifications, combinations, sub-combinations and alterations may occur depending on design requirements and other factors insofar as they are within the scope of the appended claims or the equivalents thereof.

**Claims**

1.  An optical lens (11) made of $Y_3Al_5O_{12}$ monocrystal material of a cubic crystal structure.

2.  The optical lens (11) according to claim 1,
    wherein said optical lens is configured such that part of a convex spherical surface is formed at least on the side opposite to an object-side surface.

3.  A focusing lens comprising at least a first optical lens (11) and second optical lens (12) whose optical axes are approximately aligned and which are disposed in order from an object side,
    wherein at least a material constituting said first optical lens (11) is $Y_3Al_5O_{12}$ monocrystal material of the cubic crystal structure.

4.  The focusing lens according to claim 3,
    wherein said first optical lens (11) is configured such that part of the convex spherical surface is formed at least on the side opposite to an object-side surface.

5. An optical pickup device comprising:

a light source, and
a focusing lens which includes a first optical lens (11) and second optical lens (12) disposed in order from the object side and which focuses light emitted from said light source on a predetermined track position on an optical recording medium (30) to form a light spot,

wherein at least a material constituting said first optical lens (11) is $Y_3Al_5O_{12}$ monocrystal material of the cubic crystal structure.

6. The optical pickup device according to claim 5,
wherein said first optical lens (11) is configured such that part of the convex spherical surface is formed at least on the side opposite to the object-side surface.

7. The optical pickup device according to claim 5 or 6,
wherein said optical recording medium is irradiated with near-field light by said focusing lens.

8. The optical pickup device according to claim 5, 6 or 7,
wherein both of said first optical lens (11) and said second optical lens (12) are mounted on a movable body capable of moving with respect to said optical recording medium (30).

9. The optical pickup device according to one of the claims 5 to 8,
wherein a material constituting said second optical lens (12) is $Y_3Al_5O_{12}$ monocrystal material of the cubic crystal structure.

10. The optical pickup device according to one of the claims 5 to 9,
wherein a numerical aperture of said focusing lens is 1.5 or more.

11. An optical recording and reproducing device comprising:

an optical pickup device according to one of the claims 5 to 10, and
control and drive device to control and drive said focusing lens in a focusing direction and/or tracking direction of an optical recording medium.

## FIG. 1

## FIG. 2

FIG. 3

FIG. 4

## FIG. 5

## FIG. 6

## FIG. 7

## FIG. 8